# EUROPÄISCHE PATENTSCHRIFT

(11) **EP 4 165 420 B1**
(45) Veröffentlichungstag und Bekanntmachung des Hinweises auf die Patenterteilung: **12.02.2025**
(21) Anmeldenummer: 21794118.6
(22) Anmeldetag: 12.10.2021
(51) Int. Cl.: G01R 31/3835

(54) **KORRIGIERTE KLEMMENSPANNUNG FÜR BATTERIEN**
CORRECTED TERMINAL VOLTAGE FOR BATTERIES
TENSION DE BORNE CORRIGÉE POUR BATTERIES

(30) Priorität: 12.10.2020 DE 102020126729
(43) Veröffentlichungstag der Anmeldung: 19.04.2023
(73) Patentinhaber: TWAICE Technologies GmbH, 80807 München (DE)
(72) Erfinder: SINGER, Jan, 81371 München (DE)
(74) Vertreter: Kraus & Lederer PartGmbB
(86) Internationale Anmeldenummer: PCT/EP2021/078143
(87) Internationale Veröffentlichungsnummer: WO 2022/079003

(56) Entgegenhaltungen:
- EP-A1- 2 857 854
- EP-A1- 3 267 551
- DE-A1- 102019 115 705
- US-A1- 2018 043 781
- US-A1- 2018 059 190

## Beschreibung

### TECHNISCHES GEBIET

Verschiedene Beispiele betreffen Techniken, um eine korrigierte Klemmenspannung für Batterien zu bestimmen, die mit einer Last über einen DC/AC-Wandler gekoppelt sind. Derart können zum Beispiel Störströme in einem Inverter korrigiert werden, insbesondere für ein Leerlauf-Szenario.

### HINTERGRUND

Wiederaufladbare Batterien werden in verschiedenen Anwendungsszenarien eingesetzt. Ein Beispiel sind Traktionsbatterien in Elektrofahrzeugen oder auch stationärer Energiespeicher, zum Beispiel um Lastspitzen in einem Stromnetz abzufedern.

In den verschiedenen Anwendungsszenarien ist es typischerweise hilfreich, Zustandswerte der Batterie besonders genau zu bestimmen. Zum Beispiel ist es erstrebenswert, den Ladungszustand - das heißt die verfügbare Kapazität gegenüber der Kapazität im vollgeladenen Zustand - zu bestimmen.

Druckschrift DE 10 2019 115705 A1 offenbart eine Schätzung des Batteriezustands eines elektrischen Systems unter Verwendung des Elektrodentransientenmodells. Das elektrische System beinhaltet ein Batteriepack, Sensoren und eine Steuerung. Die konfigurierten Sensoren geben gemessene Zustandssignale aus, die einen tatsächlichen Zustand der Batterierückseite anzeigen, einschließlich einer entsprechenden tatsächlichen Spannung, Strom und Temperatur jeder der mehreren Batteriezellen. Die Steuerung führt ein Verfahren aus, um als Reaktion auf die gemessenen Statussignale einen geschätzten Zustand der mehreren Batteriezellen unter Verwendung einer jeweiligen Leerlaufspannung und einer niederfrequenten transienten Spannung jeder der mehreren Batteriezellen zu erzeugen. Die Steuerung schätzt die niederfrequenten transienten Spannungen unter Verwendung eines porösen Elektroden-Transientenmodells (PET) als Teil eines Modellsatzes, wobei das PET-Modell Leerlaufspannungselemente aufweist, die eine ungleichmäßige Ladungsverteilung innerhalb einer Zellelektrode darstellen. Der Ladezustand (SOC) des Akkupacks wird anhand der geschätzten Spannungen geschätzt. Ein Betriebszustand des elektrischen Systems wird in Echtzeit als Reaktion auf den geschätzten SOC gesteuert.

Druckschrift EP 3 267 551 A1 offenbart eine Batteriesteuerungsvorrichtung, die in der Lage ist, einen Lade-/Entladestrom mit einer hohen Genauigkeit zu erhalten. Die Batteriesteuerungsvorrichtung beinhaltet eine Zeitpunkteinstelleinheit, die eine Spannungsdifferenz berechnet, die durch Subtraktion einer berechneten Leerlaufspannung von einer gemessenen Ruhespannung erhalten wird, und erste und zweite Zeitpunkte einstellt, bei denen ein Absolutwert der Spannungsdifferenz gleich oder kleiner als ein vorbestimmter Wert wird und ein Absolutwert einer Differenz in der Leerlaufspannung gleich oder kleiner als ein vorbestimmter Wert wird. Die Batteriesteuerungsvorrichtung beinhaltet ferner die Stromintegralbetragsberechnungseinheit, um den Stromintegralbetrag zu erhalten, der ein Integralbetrag mit der Zeit des Stroms ist, der durch die Zelle von dem ersten Zeitpunkt zu dem zweiten Zeitpunkt fließt, wobei die Stromkorrekturbetragsberechnungseinheit den in einem von der Stromerfassungseinheit ausgegebenen Erfassungssignal enthaltenen Stromfehler berechnet und den Stromfehler als den Stromkorrekturbetrag auf der Grundlage des Stromintegralbetrags und einer Zeit vom ersten Zeitpunkt bis zum zweiten Zeitpunkt festlegt, und die Stromkorrektureinheit, die das Erfassungssignal unter Verwendung des Stromkorrekturbetrags korrigiert.

Druckschrift US 2018/059190 A1 offenbart eine Zustandsabschätzung eines Energiesystems. Eine Reihe von Varianten kann Produkte und Verfahren zur Schätzung des Zustands eines Energiesystems umfassen. Mindestens ein Sensor kann eine Spannung und einen Strom des Energiespeichersystems überwachen. Ein elektronisches Steuergerät kann kommunikativ mit dem Energiespeichersystem gekoppelt sein und Eingaben von dem Sensor empfangen. Ein Schaltkreis kann für das Energiespeichersystem repräsentativ sein und kann in der elektronischen Steuerung entsprechend definiert werden. Die Schaltung kann einen Zustand des Energiespeichersystems aus einem Messwert der Spannung und des Stroms abschätzen.

Druckschrift EP 2 857 854 A1 offenbart eine Batteriesteuerungsvorrichtung, die mindestens einen zulässigen Strom und eine zulässige Leistung während des Ladens/Entladens einer Batterie aus einer Leerlaufspannung und einem Innenwiderstand der Batterie berechnet und die Leerlaufspannung und/oder den Innenwiderstand entsprechend den Lade-/Entladesituationen der Batterie korrigiert.

### KURZZUSAMMENFASSUNG DER ERFINDUNG

Deshalb besteht ein Bedarf für Techniken, um ein oder mehrere Zustandswerte der Batterie besonders genau zu bestimmen.

Diese Aufgabe wird gelöst von den Merkmalen der unabhängigen Patentansprüche. Die Merkmale der abhängigen Patentansprüche definieren Ausführungsformen.

Gemäß verschiedenen Beispielen ist es möglich, ein oder mehrere Zustandswerte der Batterie basierend auf einem korrigierten Wert für eine Klemmenspannung der Batterie zu bestimmen. Ein Beispiel für Zustandswerte sind z.B. der Alterungszustand oder der Ladezustand.

Die Korrektur der Klemmenspannung kann basierend auf einem Korrekturterm erfolgen, der unter Berücksichtigung eines DC/AC-Wandlers, über den die Batterie mit einer Last verbunden ist, bestimmt wird. Zum Beispiel können unterschiedliche Korrekturterme für unterschiedliche Typen von DC/AC-Wandlern verwendet werden. Es werden insbesondere auch denkbar, dass der Korrekturterm basierend auf ein oder mehreren Betriebsparametern des DC/AC-Wandlers bestimmt wird.

Ein Verfahren umfasst das Erhalten eines Messwerts für eine Klemmenspannung einer Batterie. Die Batterie ist über einen DC/AC-Wandler mit einer Last gekoppelt. Außerdem umfasst das Verfahren das Bestimmen eines korrigierten Werts der Klemmenspannung, basierend auf dem Messwert für die Klemmenspannung sowie weiterhin basierend auf einem Korrekturterm. Der Korrekturterm hängt von ein oder mehreren Betriebsparametern des DC/AC-Wandlers ab. Ferner umfasst das Verfahren auch das Bestimmen eines Zustandswerts der Batterie basierend auf dem korrigierten Wert der Klemmenspannung.

Ein Computer-Programm oder ein Computer-Programmprodukt oder ein computerlesbares Speichermedium umfasst Programmcode. Dieser kann von einem Prozessor geladen und ausgeführt werden. Wenn der Prozessor den Programmcode ausführt, wird ein Verfahren ausgeführt. Das Verfahren umfasst das Erhalten eines Messwerts für eine Klemmenspannung einer Batterie. Die Batterie ist über einen DC/AC-Wandler mit einer Last gekoppelt. Außerdem umfasst das Verfahren das Bestimmen eines korrigierten Werts der Klemmenspannung, basierend auf dem Messwert für die Klemmenspannung sowie weiterhin basierend auf einem Korrekturterm. Der Korrekturterm hängt von ein oder mehreren Betriebsparametern des DC/AC-Wandlers ab. Ferner umfasst das Verfahren auch das Bestimmen eines Zustandswerts der Batterie basierend auf dem korrigierten Wert der Klemmenspannung.

Eine Vorrichtung umfasst einen Prozessor und einen Speicher. Der Prozessor kann Programmcode aus dem Speicher laden und im Programmcode ausführen. Das bewirkt, dass der Prozessor einen Messwert für eine Klemmenspannung einer Batterie erhält. Dabei ist die Batterie über einen DC/AC-Wandler mit einer Last gekoppelt. Außerdem bestimmt der Prozessor einen korrigierten Wert der Klemmenspannung. Das basiert auf dem Messwert für die Klemmenspannung sowie weiterhin auf einem Korrekturterm. Der Korrekturterm hängt von ein oder mehreren Betriebsparametern des DC/AC-Wandlers ab. Außerdem bestimmt der Prozessor einen Zustandswert der Batterie basierend auf dem korrigierten Wert der Klemmenspannung.

Die oben dargelegten Merkmale und Merkmale, die nachfolgend beschrieben werden, können nicht nur in den entsprechenden explizit dargelegten Kombinationen verwendet werden, sondern auch in weiteren Kombinationen oder isoliert, ohne den Schutzumfang der vorliegenden Erfindung zu verlassen, welcher von den angehängten Ansprüchen definiert wird.

### KURZE BESCHREIBUNG DER FIGUREN

FIG. 1 illustriert schematisch ein System umfassend mehrere Batterien und einen Server gemäß verschiedenen Beispielen.
FIG. 2 illustriert Details einer Batterie gemäß verschiedenen Beispielen.
FIG. 3 illustriert Details eines Servers gemäß verschiedenen Beispielen.
FIG. 4 illustriert schematisch ein System umfassen eine Batterie, einen DC/AC-Wandler sowie eine Last gemäß verschiedenen Beispielen.
FIG. 5 ist ein Flussdiagramm eines beispielhaften Verfahrens.
FIG. 6 illustriert schematisch einen Ersatzschaltkreis für eine Batterie gemäß verschiedenen Beispielen.

### DETAILLIERTE BESCHREIBUNG VON AUSFÜHRUNGSFORMEN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein. Funktionale Einheiten können als Hardware, Software oder eine Kombination aus Hardware und Software implementiert werden.

Nachfolgend werden Techniken im Zusammenhang mit der Charakterisierung von wiederaufladbaren Batterien beschrieben. Die hierin beschriebenen Techniken können im Zusammenhang mit unterschiedlichsten Typen von Batterien eingesetzt werden, beispielsweise im Zusammenhang mit Batterien auf Lithium-Ionen-Basis, wie z.B. Lithium-Nickel-Mangan-Kobaltoxid-Batterien oder Lithium-Manganoxid-Batterien.

Die hierin beschriebenen Batterien können für Batterien in unterschiedlichen Anwendungsszenarien eingesetzt werden, beispielsweise für Batterien die in Geräten wie Kraftfahrzeugen oder Drohnen oder tragbaren elektronischen Geräten wie etwa Mobilfunkgeräte eingesetzt werden, etwa Traktionsbatterien. Es wäre auch denkbar, die hierin beschriebenen Batterien in Form von stationären Energiespeichern einzusetzen. Innenraum- oder Außenraumanwendungen sind denkbar, die sich vor allem hinsichtlich der Temperaturbereiche unterscheiden. Anwendungsszenarien umfassen: stationärer Energiespeicher in einem Mikrostromnetz; Energiespeicher für mobile Anwendungen; Niederlastenergiespeicher; Energiespeicher für Leichtelektrofahrzeuge wie z.B. Fahrräder oder Roller; Energiespeicher für Elektropersonenkraftwagen; Innenraumanwendung; und Außenraumanwendung.

Verschiedene Beispiele der Erfindung betreffen Techniken, um einen Zustandswert einer Batterie zu bestimmen. Beispiele für Zustandswerte, die auf Grundlage der Klemmenspannung bestimmt werden können, umfassen: Ladezustand, Alterungszustand oder Leistungsfähigkeit. Weitere Beispiele für Zustandswerte sind Kapazität und Impedanz der Batterie.

Beim Bestimmen des Zustandswerts kann nach verschiedenen Beispielen die Klemmenspannung der Batterie berücksichtigt werden. Insbesondere kann ein korrigierter Wert der Klemmenspannung der Batterie berücksichtigt werden. Der korrigierte Wert kompensiert oder reduziert Verfälschungen der Klemmenspannung aufgrund von Störströmen oder anderen Einflüssen.

Verschiedene Beispiele der Erfindung beruhen auf der Erkenntnis, dass Batterien typischerweise über eine Leistungselektronik-Schaltung mit einem Verbraucher verbunden sind. Der Verbraucher kann zum Beispiel ein Antrieb eines Elektro-Kraftfahrzeugs sein oder ein Energienetz, zum Beispiel ein Mikrostromnetz, bei einem stationären Batteriespeicher. Motoren benötigen einen Wechselstrom und die Leistungselektronik-Schaltung kann den Gleichstrom der Batterie wandeln in den Wechselstrom (DC/AC-Wandler). Typischerweise werden Inverter-Schaltungen dazu verwendet, um eine Wandlung des Gleichstroms der Batterie in Wechselstrom durchzuführen. Eine typische Inverter-Schaltung stellt einen dreiphasigen Stromfluss mit einer bestimmten Frequenz auf der Wechselstromseite bereit.

Es wurde beobachtet, dass der DC/AC-Wandler Störströme bedingen kann, welche die Messung der Klemmenspannung verfälschen. Dies gilt insbesondere für ein Leerlauf-Szenario. Die Klemmenspannung wird dabei ohne Belastung durch den Verbraucher gemessen (Leerlauf-Szenario). Das bedeutet, dass die von der Inverter-Schaltung ausgegebene elektrische Leistung klein ist.

Um die Klemmenspannung zu bestimmen, kann ein entsprechender Messwert der Batteriespannung erhalten werden, etwa von einem Batteriemanagementsystem. Verschiedene Beispiele beruhen auf der Erkenntnis, dass insbesondere der Leerlauf-Zustand (aber auch andere Zustände) in typischen Inverter-Schaltungen mit signifikanten Störströmen assoziiert ist.

Dies liegt an den Schaltprozessen von Schaltelementen. Die schnellen Änderungen des Stromflusses bewirken Störströme. Beispielsweise ist es möglich, dass typische Inverter-Schaltungen Schaltelemente umfassen, die insbesondere im Leerlauf-Zustand gleichphasig geschaltet werden können. Im Falle einer Inverter-Schaltung mit IGBT-Schalttopologie schalten alle Halbbrücken zeitgleich. Entsprechend groß ist ein Störpegel auf der DC-Seite der Inverter-Schaltung im Leerlauf-Zustand. Dies betrifft sowohl Stromflüsse im Gleichtakt, wie auch im Gegentakt zum Schalttakt der Schaltelemente.

Entsprechend ist es gemäß verschiedenen hierin beschriebenen Beispielen möglich, einen Messwert für die Klemmenspannung der Batterie zu erhalten, wobei die Batterie über den DC/AC-Wandler mit einer Last gekoppelt ist. Dann kann ein korrigierter Wert der Klemmenspannung basierend auf diesen Messwert für die Klemmenspannung bestimmt werden, sowie ferner basierend auf einem Korrekturterm. Außerdem umfasst das Verfahren auch das Bestimmen eines Zustandswerts der Batterie basierend auf dem korrigierten Wert der Klemmenspannung.

Der Korrekturterm kann also elektromagnetische Störungen berücksichtigen, die durch den DC/AC-Wandler verursacht werden. Insbesondere können die elektromagnetischen Störungen Stromflüsse beinhalten, die beispielsweise durch Magnetfelder oder andere transiente Effekte induziert werden, die durch das Schalten von Schaltelementen des DC/AC-Wandlers verursacht werden.

Der Korrekturterm kann von ein oder mehreren Betriebsparametern des DC/AC-Wandlers abhängen. Wenn die ein oder mehreren Betriebsparameter des DC/AC-Wandlers berücksichtigt werden, kann also der Korrekturterm dynamisch bestimmt werden, je nach Betriebssituationen des DC/AC-Wandlers. Dadurch kann der Korrekturterm besonders genau bestimmt werden.

Verschiedene Beispiele beruhen auf der Erkenntnis, dass die Größe des Korrekturterms abhängen kann von einer Schaltspannung der Schaltelemente des DC/AC-Wandlers, einer Schaltfrequenz der Schaltelemente des DC/AC-Wandlers und/oder einer Gesamtimpedanz des Systems umfassend Batterie und DC/AC-Wandler.

Beispielsweise wurde beobachtet, dass Gleichtakt-Störungen bei einem Kfz-Inverter von 140 dBµV Störpegel einer Störspannung von 10 V entsprechen, hervorgerufen von Gleichtakt-Strömen, welche zum Beispiel durch parasitäre Kapazitäten der Schaltelemente gegenüber der Kühlkörper-Gehäusemasse entstehen. Auch in einem mit einem Netz gekoppelten stationären Batteriesystemen wurden Störströme im Gleichtakt mit der Schaltfrequenz von ca. 8 A beobachtet.

Die induzierten Störströme im Gleichtakt oder im Gegentakt werden aus der Batterie als Energiequelle gespeist. Das bedeutet, dass auch ohne abgegebene elektrische Leistung an die Last - d.h. im Leerlauf-Szenario - Energie aus der Batterie entnommen wird. Dies bedeutet, dass die Batterie effektiv belastet wird und entsprechend der Messwert für die Klemmenspannung der Batterie gegenüber der nominellen Klemmenspannung verfälscht ist. Diese Verfälschung kann vom Korrekturterm berücksichtigt werden.

Dabei sind in den verschiedenen Varianten unterschiedliche Techniken denkbar, um den Korrekturterm zu bestimmen. Einige Varianten sind nachfolgend in der TAB. 1 wiedergegeben.

**TAB. 1: Verschiedene Varianten für Betriebsparameter des DC/AC-Wandlers, die bei der Bestimmung des Korrekturterms berücksichtigt werden können.**

| | Kurze Beschreibung | Beispielhafte Implementierung |
|---|---|---|
| I | Schaltspannung und/oder Schaltfrequenz | Beispielsweise wäre es möglich, dass der Korrekturterm in Abhängigkeit von der Schaltspannung und/oder der Schaltfrequenz eines Treibers der Schaltelemente des DC/AC-Wandlers bestimmt wird. Zum Beispiel wäre es denkbar, dass entsprechende Betriebsparameter gemessen oder übermittelt werden. Zum Beispiel könnten entsprechende Betriebsparameter in einer Digitaldomäne des Treibers abgegriffen werden und an die Einheit, welche den Korrekturterm bestimmt, bereitgestellt werden. |
| II | Messung der Störströme | Die Störströme können auch gemessen werden. Dazu können Strom-Messsensoren etwa auf der DC-Seite des DC/AC-Wandlers vorgesehen sein. Zum Beispiel könnten die Wechselströme induktiv gemessen werden. |

Zum Beispiel werde es denkbar, dass der Korrekturterm - zum Beispiel in Abhängigkeit der in TAB. 1 genannten Betriebsparametern - in einer Nachschlagetabelle nachgeschlagen wird. Es wäre auch möglich, dass ein vorparametrisiertes Modell verfügbar ist, das den Korrekturterm in Abhängigkeit von den Messparametern bereitstellt.

Dabei gibt es wiederum unterschiedliche Varianten, um eine entsprechende Nachschlagetabelle zu befüllen oder en solches Modell zu parametrisieren. Zum Beispiel wäre es denkbar, dass der Korrekturterm in einem Labor-Aufbau empirisch ermittelt wird, etwa als Funktion der Betriebsparameter des DC/AC-Wandlers. Zum Beispiel kann eine EMV-Messung der Leistungselektronik durchgeführt werden, etwa entsprechend der CISPR 25:2016 c-Norm. Es ist dann möglich, dass der Korrekturtabellen dazu verwendet wird, um die wahre Klemmenspannung mittels des korrigierten Werts zu nähern.

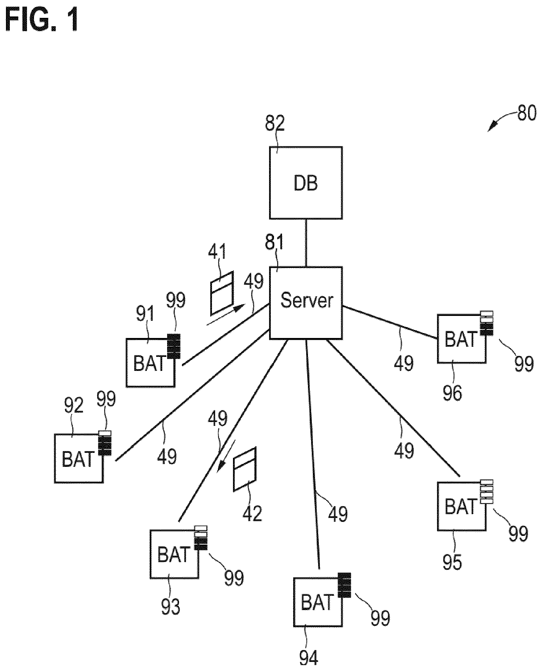

FIG. 1 illustriert Aspekte im Zusammenhang mit einem System 80. Das System 80 umfasst einen Server 81, der mit einer Datenbank 82 verbunden ist. Außerdem umfasst das System 80 Kommunikationsverbindungen 49 zwischen dem Server 81 und jeder von mehreren Batterien 91-96. Die Kommunikationsverbindungen 49 könnten zum Beispiel über ein Mobilfunknetzwerk implementiert werden. Beispielsweise können die Batterien 91-96 ein Ensemble bilden, d.h. alle vom gleichen Typ sein.

In FIG. 1 ist beispielhaft illustriert, dass die Batterien 91-96 über die Kommunikationsverbindungen 49 Messdaten 41 an den Server 81 senden können. Beispielsweise wäre es möglich, dass die Messdaten 41 indikativ sind für ein oder mehrere Messwerte von Zustandsgrößen der jeweiligen Batterie 91-96, z.B. Ladungszustand, Stromfluss, Spannung, Temperatur, usw.

In FIG. 1 ist auch beispielhaft illustriert, dass der Server 81 über die Kommunikationsverbindungen 49 Steuerdaten 42 an die Batterien 91-96 senden kann. Beispielsweise wäre es möglich, dass die Steuerdaten 42 ein oder mehrere Betriebsgrenzen für den zukünftigen Betrieb der jeweiligen Batterie 91-96 indizieren. Zum Beispiel könnten die Steuerdaten ein oder mehrere Steuerparameter für ein Thermomanagement der jeweiligen Batterie 91-96 und/oder ein Lademanagement der jeweiligen Batterie 91-96 indizieren. Durch Verwendung der Steuerdaten 42 kann der Server 81 also den Betrieb der Batterien 91-96 beeinflussen bzw. steuern. Dies könnte z.B. basieren auf einem Alterungswert, der vom Server 81 für die jeweilige Batterie ermittelt wird.

In FIG. 1 ist außerdem für jede der Batterien 91-96 schematisch ein Zustandswert 99 illustriert. Beispiele für Zustandswerte sind z.B. Ladungszustand (engl. state of charge, SOC), Alterungszustand, usw. Nachfolgend werden Techniken beschrieben, wie ein solcher Zustandswert 99 besonders genau bestimmt werden kann.

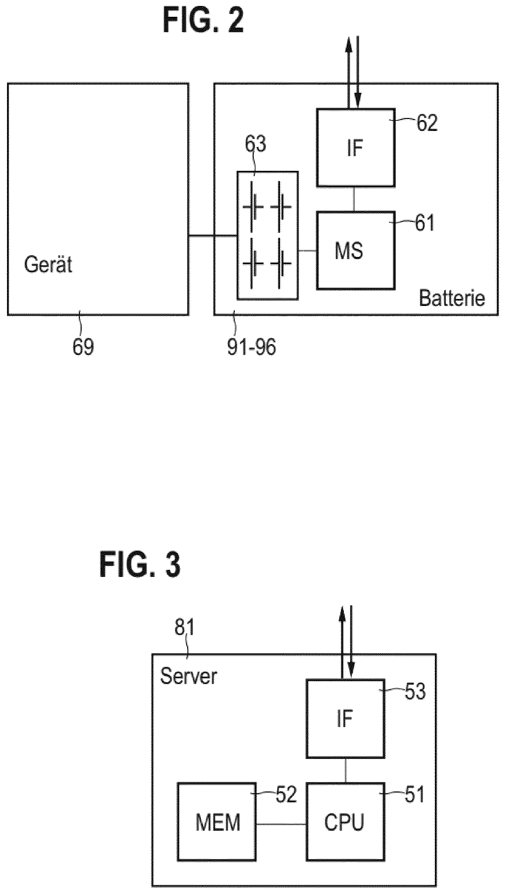

FIG. 2 illustriert Aspekte im Zusammenhang mit den Batterien 91-96. Die Batterien 91-96 sind mit einem jeweiligen Gerät 69 gekoppelt. Dieses Gerät - z.B. ein Elektromotor - wird durch elektrische Energie aus der jeweiligen Batterie 91-96 getrieben. Es stellt also eine elektrische Last dar.

Die Batterien 91-96 umfassen bzw. sind assoziiert mit ein oder mehreren Managementsysteme 61, z.B. ein BMS oder eine andere Steuerlogik wie eine on-board-unit im Falle eines Fahrzeugs. Das Managementsystem 61 kann zum Beispiel durch Software auf einem CPU implementiert sein. Alternativ oder zusätzlich könnte zum Beispiel ein Applikations-spezifischer Schaltkreis (ASIC) oder ein Feldprogrammierbares gated array (FPGA) verwendet werden. Die Batterien 91-96 könnten z.B. über ein Bussystem mit dem Managementsystem 61 kommunizieren. Die Batterien 91-96 umfassen auch eine Kommunikationsschnittstelle 62. Das Managementsystem 61 kann über die Kommunikationsschnittstelle 62 eine Kommunikationsverbindung 49 mit dem Server 81 aufbauen.

Während in FIG. 2 das Managementsystem 61 separat von den Batterien 91-96 gezeichnet ist, wäre es in anderen Beispielen auch möglich, dass das Managementsystem 61 Teil der Batterien 91-96 ist.

Außerdem umfassen die Batterien 91-96 ein oder mehrere Batterieblöcke 63. Jeder Batterieblock 63 umfasst typischerweise eine Anzahl von parallel geschalteten und/oder seriell geschalteten Batteriezellen. Dort kann elektrische Energie gespeichert werden.

Typischerweise kann das Managementsystem 61 auf ein oder mehrere Sensoren in den ein oder mehreren Batterieblöcken 63 zurückgreifen. Die Sensoren können zum Beispiel Zustandsgrößen der jeweiligen Batterie messen und entsprechende Messwerte bereitstellen, etwa den Stromfluss und/oder die Spannung in zumindest einigen der Batteriezellen. Die Sensoren können alternativ oder zusätzlich auch andere Zustandsgrößen im Zusammenhang mit zumindest einigen der Batteriezellen messen, beispielsweise Temperatur, Volumen, Druck, etc. Das Managementsystem 61 kann dann eingerichtet sein, um ein oder mehrere solcher Messwerte von Sensoren in Form von Messdaten 41 an den Server 81 zu senden.

Die Messwerte können zu einem kleineren oder größeren Umfang von dem Managementsystem 61 vorverarbeitet werden, bevor diese in Form der Messdaten 41 gesendet werden. Zum Beispiel wäre eine Komprimierung denkbar, etwa in Form eines Lastkollektiv. Es könnten auch Messwerte gefiltert werden, zum Beispiel Ereignis-bezogen.

FIG. 3 illustriert Aspekte im Zusammenhang mit dem Server 81. Der Server 81 umfasst einen Prozessor 51 sowie einen Speicher 52. Der Speicher 52 kann ein flüchtiges Speicherelement und/oder ein nicht-flüchtiges Speicherelement umfassen. Außerdem umfasst der Server 81 auch eine Kommunikationsschnittstelle 53. Der Prozessor 51 kann über die Kommunikationsschnittstelle 53 eine Kommunikationsverbindung 49 mit jeder der Batterien 91-96 und der Datenbank 82 aufbauen.

Zum Beispiel kann Programmcode im Speicher 52 gespeichert sein und vom Prozessor 51 geladen werden. Der Prozessor 51 kann dann den Programmcode ausführen. Das Ausführen des Programmcodes bewirkt, dass der Prozessor 51 ein oder mehrere der folgenden Prozesse ausführt, wie sie im Zusammenhang mit den verschiedenen Beispielen hierin im Detail beschrieben sind: Charakterisierung von Batterien 91-96; Bestimmen eines korrigierten Werts für die Klemmenspannung einer Batterie; bestimmen eines Zustandswert der Batterie basierend auf dem korrigierten Wert der Klemmspannung; etc.

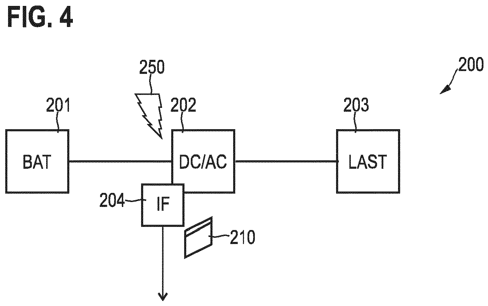

FIG. 4 illustriert schematisch ein System 200, welches eine Batterie 201, einen DC-AC-Wandler 202, sowie eine Last 203 umfasst. Die Batterie 201 kann eine der Batterien 91-96 aus FIG. 1 implementieren. Entsprechend kann die Last 203 dem Gerät 69 entsprechen. Der DC/AC-Wandler 202 kann zum Beispiel eine Halbbrücken-Architektur oder eine Vollbrücken-Architektur verwenden.

Beim Betrieb des Systems 200 kann es zu Störströmen 250 kommen, welche die Messung der Klemmenspannung der Batterie 201 verfälschen.

Um entsprechende Effekte zu korrigieren, können Zustandsdaten 210 betreffend ein oder mehrere Betriebsparameter des DC/AC-Wandlers 202 bereitgestellt werden. Dazu kann eine entsprechende Schnittstelle 204 des DC/AC-Wandlers 202 vorgesehen sein, welche die Zustandsdaten 210 bereitstellt. Zum Beispiel könnte die Schnittstelle 204 in durch einen Mikrocontroller ausgebildet sein, der eine Treiberschaltung für Schaltelemente des DC/AC-Wandlers 202 ansteuert. Beispielsweise wäre es denkbar, dass die Zustandsdaten 210 an den Server 81 übermittelt werden, z.B. als Teil der Messdaten 41 (vgl. FIG. 1).

Basierend auf den Zustandsdaten 210 kann dann ein korrigierter Wert der Klemmenspannung bestimmt werden. Dieser kann als Grundlage für das Bestimmen eines Zustandswerts 99 der Batterie 201 dienen.

Ein entsprechender Korrekturterm kann beispielsweise am Server 81 bestimmt werden; es wäre aber auch denkbar, dass der Korrekturterm bereits durch das Managementsystem der Batterie 201 bestimmt wird (vergleiche FIG. 2: Managementsystem 61); in einem solchen Fall können die Zustandsdaten 210 an das Managementsystem übergeben werden.

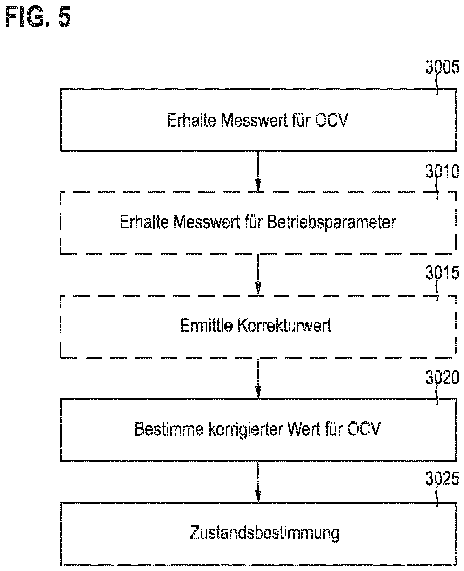

FIG. 5 ist ein Flussdiagramm eines beispielhaften Verfahrens. Das Verfahren aus FIG. 5 kann zum Beispiel vom Server 81 ausgeführt werden. Es wäre auch denkbar, dass das Verfahren aus FIG. 5 zumindest teilweise von einem Managementsystem einer der Batterien 91-96 ausgeführt wird (vergleiche FIG. 1). In FIG. 5 sind optionale Blöcke mit gestrichelten Linien dargestellt.

Zunächst wird in Block 3005 ein Messwert für die Klemmenspannung der Batterie erhalten. Die Klemmenspannung ist definiert zwischen Pluspol und Minuspol der Batterie. Dies kann zum Beispiel in Form der Messdaten 41 geschehen.

In manchen Beispielen gilt: Der Messwert für die Klemmenspannung kann in einem nominellen Leerlaufbetrieb der Batterie 91-96 erhalten werden. Der nominellen Leerlaufbetrieb kann zum Beispiel durch einen Ruhezustand des jeweiligen Verbrauchers (vergleiche FIG. 2: Gerät 69; sowie FIG. 4: Last 203) charakterisiert sein. Dann beschreibt der Messwert für die Klemmenspannung eine Leerlaufspannung der Batterie.

Dann kann optionalen Block 3010 ein Messwert für einen oder für mehrere Betriebsparameter des DC/AC-Wandlers erhalten werden (vergleiche FIG. 4: Zustandsdaten 210). Dabei ist es nicht in allen Implementierungen notwendig, dass ein aktueller Messwert für Betriebsparameter des DC/AC-Wandlers erhalten werden. Vielmehr wäre es in manchen Beispielen auch denkbar, dass in manchen Beispielen ein oder mehrere Betriebsparameter des DC/AC-Wandlers fest vorgegeben sind, das heißt nicht dynamisch auf Grundlage von Messwerten bestimmt werden müssen.

Je nach Implementierung der ein oder mehreren Betriebsparameter können unterschiedliche Messwerte in Block 3010 erhalten werden. In einem Beispiel wäre es zum Beispiel denkbar, dass ein Messwert für eine Schaltspannung und/oder eine Schaltfrequenz von ein oder mehreren Schaltelementen (etwa. Feldeffekttransistoren oder anderen Transistoren) des DC/AC-Wandlers erhalten wird.

In einem weiteren Beispiel wäre es denkbar, dass ein Messwert für einen Stromfluss im DC/AC-Wandler - zum Beispiel einen Gleichtakt-Stromfluss und/oder einen Gegentakt-Stromfluss - erhalten wird.

Es ist dann in Block 3015 optional möglich, einen Korrekturwert für den Messwert für die Klemmenspannung zu ermitteln. Dies basiert auf dem Messwert für ein oder mehrere Betriebsparameter aus Block 3010. In manchen Beispielen wäre es auch denkbar, dass der Korrekturwert fix vorgegeben ist.

Der Korrekturwert könnte zum Beispiel durch Nachschlagen in einer Nachschlagetabelle ermittelt werden. Zum Beispiel kann die Nachschlagetabelle unterschiedliche Korrekturwerte beinhalten, etwa für unterschiedliche Schaltspannungen und/oder Schaltfrequenzen der Schaltelemente des DC/AC-Wandlers. Es wäre auch denkbar, dass anstatt einer Nachschlagetabelle ein parametrisiertes Modell verwendet wird, welches als Eingabe ein oder mehrere Betriebsparameter des DC/AC-Wandlers erhält und als Ausgabe den Korrekturwert bereitstellt. Ein solches Modell könnte beispielsweise auf Grundlage von Labormessungen parametriert werden.

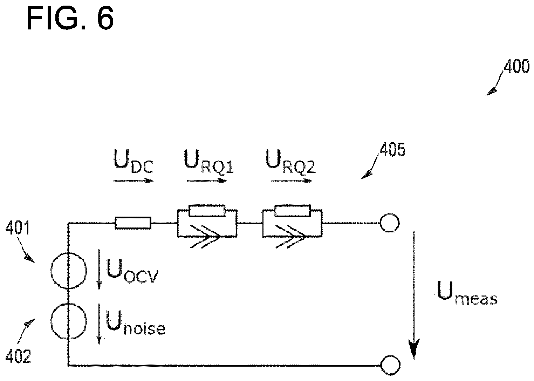

Anschließend wird in Block 3020 der korrigierte Wert der Klemmenspannung bestimmt, und zwar basierend auf dem Messwert aus Block 3005 sowie einem Korrekturwert, etwa dem in Block 3015 ermittelten Korrekturwert. Als allgemeine Regel gibt es unterschiedliche Möglichkeiten, um den korrigierten Wert der Klemmenspannung zu bestimmen. Eine Möglichkeit bestünde darin, in einem Batterie-Ersatzschaltkreis entsprechende Spannungsquellen für Steuerspannung und Klemmenspannung zu berücksichtigen. Ein solches Beispiel ist in FIG. 6 dargestellt. In FIG. 6 ist ein Batterie-Ersatzschaltkreis dargestellt. Dieser weist eine Reihe von Widerständen 405 auf, insbesondere einen DC-Widerstand sowie AC-Widerstände. Insoweit ist der Batterie-Ersatzschaltkreis Impedanzbasiert. In FIG. 6 ist auch ersichtlich, dass eine Reihenschaltung einer Spannungsquelle 401 - die eine Spannung aufweist, die dem korrigierten Wert der Klemmenspannung entspricht - und einer weiteren Spannungsquelle 402 - die eine Spannung aufweist, die dem Korrekturterm entspricht - verwendet wird. Die Summe der Spannungen der Spannungsquellen 401, 402 entspricht dem Messwert für die Klemmenspannung.

Dann kann in Block 3025 ein Zustandswert 99 der Batterie basierend auf dem korrigierten Wert der Klemmenspannung aus Block 3020, d.h. der Spannungsquelle 401, bestimmt werden. Beispielsweise könnte ein aktueller Ladungszustand (SOC) bestimmt werden oder es könnte auch eine Alterung der Batterie erfolgen.

Selbstverständlich können die Merkmale der vorab beschriebenen Ausführungsformen und Aspekte der Erfindung miteinander kombiniert werden. Insbesondere können die Merkmale nicht nur in den beschriebenen Kombinationen, sondern auch in anderen Kombinationen oder für sich genommen verwendet werden, ohne das Gebiet der Erfindung zu verlassen, welches von den angehängten Ansprüchen definiert wird.

## Patentansprüche

1. Verfahren, welches umfasst:
- Erhalten eines Messwerts für eine Klemmenspannung einer Batterie (91-96, 201), die über einen DC/AC-Wandler (202) mit einer Last (69, 203) gekoppelt ist,
- Bestimmen eines korrigierten Werts der Klemmenspannung basierend auf dem Messwert für die Klemmenspannung und weiterhin basierend auf einem Korrekturterm, der von ein oder mehreren Betriebsparametern des DC/AC-Wandlers (202) abhängt, und
- Bestimmen eines Zustandswerts (99) der Batterie (91-96, 201) basierend auf dem korrigierten Wert der Klemmenspannung,
**dadurch gekennzeichnet, dass** das Verfahren weiter umfasst:
- Erhalten eines Messwerts für eine Schaltspannung und/oder eine Schaltfrequenz von ein oder mehreren Schaltelementen des DC/AC-Wandlers (202),
wobei die ein oder mehreren Betriebsparameter des DC/AC-Wandlers (202) die Schaltspannung und/oder die Schaltfrequenz umfassen.

2. Verfahren nach Anspruch 1, wobei das Verfahren weiterhin umfasst:
- Erhalten eines Messwerts für einen Stromfluss im DC/AC-Wandler (202),
wobei die ein oder mehreren Betriebsparameter des DC/AC-Wandlers (202) den Stromfluss im DC/AC-Wandler (202) umfassen.

3. Verfahren nach Anspruch 2,
wobei der Stromfluss zumindest einen von einem Gleichtakt-Stromfluss und einem Gegentakt-Stromfluss umfasst.

4. Verfahren nach einem der voranstehenden Ansprüche, wobei das Verfahren weiterhin umfasst:
- Ermitteln des Korrekturterms mittels Nachschlagen in einer Nachschlagetabelle basierend auf den ein oder mehreren Betriebsparametern des DC/AC-Wandlers (202).

5. Verfahren nach einem der voranstehenden Ansprüche, wobei das Verfahren weiterhin umfasst:
- Parametrieren eines Impedanz-basierten Ersatzschaltkreises (400) der Batterie (91-96, 201) basierend auf dem korrigierten Wert der Klemmenspannung.

6. Verfahren nach einem der voranstehenden Ansprüche,
wobei der Messwert für die Klemmenspannung eine Leerlaufspannung der Batterie (91-96, 201) beschreibt.

7. Verfahren nach einem der voranstehenden Ansprüche, wobei das Verfahren weiterhin umfasst:
- Empfangen von Zustandsdaten (210), die indikativ für den ein oder die mehreren Betriebsparameter des DC/AC-Wandlers (202) sind.

8. Vorrichtung (61, 81) mit einem Prozessor, der eingerichtet ist, um folgende Schritte auszuführen:
- Erhalten eines Messwerts für eine Klemmenspannung einer Batterie (91-96, 201), die über einen DC/AC-Wandler (202) mit einer Last (69, 203) gekoppelt ist,
- Bestimmen eines korrigierten Werts der Klemmenspannung basierend auf dem Messwert für die Klemmenspannung und weiterhin basierend auf einem Korrekturterm, der von ein oder mehreren Betriebsparametern des DC/AC-Wandlers (202) abhängt, und
- Bestimmen eines Zustandswerts (99) der Batterie (91-96, 201) basierend auf dem korrigierten Wert der Klemmenspannung,
**dadurch gekennzeichnet, dass** der Prozessor weiterhin eingerichtet ist, folgenden Schritt auszuführen:
- Erhalten eines Messwerts für eine Schaltspannung und/oder eine Schaltfrequenz von ein oder mehreren Schaltelementen des DC/AC-Wandlers (202),
wobei die ein oder mehreren Betriebsparameter des DC/AC-Wandlers (202) die Schaltspannung und/oder die Schaltfrequenz umfassen.

9. Vorrichtung nach Anspruch 8, wobei der Prozessor weiterhin eingerichtet ist, um das Verfahren nach einem der Ansprüche 1 bis 7 auszuführen.

## Claims

1. Method, which comprises:
- obtaining a measured value for a terminal voltage of a battery (91-96, 201), which is coupled with a load (69, 203) via a DC/AC inverter (202),
- determining a corrected value of the terminal voltage based on the measured value for the terminal voltage and furthermore based on a correction term which depends on one or more operating parameters of the DC/AC inverter (202), and
- determining a state value (99) of the battery (91-96, 201) based on the corrected value of the terminal voltage,
**characterized in that** the method further comprises:
- obtaining a measured value for a switching voltage and/or a switching frequency of one or more switching elements of the DC/AC inverter (202),
wherein the one or more operating parameters of the DC/AC inverter (202) include the switching voltage and/or the switching frequency.

2. Method according to Claim 1, wherein the method furthermore comprises:
- obtaining a measured value for a current flow in the DC/AC inverter (202),
wherein the one or more operating parameters of the DC/AC inverter (202) include current flow in the DC/AC inverter (202).

3. Method according to Claim 2,
wherein the current flow comprises at least one of a common-mode current flow and a differential-mode current flow.

4. Method according to one of the preceding claims, wherein the method furthermore comprises:
- determining the correction term based on the one or more operating parameters of the DC/AC inverter (202) by means of a lookup in a lookup table.

5. Method according to one of the preceding claims, wherein the method furthermore comprises:
- parametrizing an impedance-based replacement circuit (400) of the battery (91-96, 201) based on the corrected value of the terminal voltage.

6. Method according to one of the preceding claims,
wherein the measured value for the terminal voltage describes an open-circuit voltage of the battery (91-96, 201).

7. Method according to one of the preceding claims, wherein the method furthermore comprises:
- receiving state data (210) which are indicative for the one or the plurality of operating parameters of the DC/AC inverter (202).

8. Device (61, 81) having a processor which is set up for executing the following steps:
- obtaining a measured value for a terminal voltage of a battery (91-96, 201), which is coupled with a load (69, 203) via a DC/AC inverter (202),
- determining a corrected value of the terminal voltage based on the measured value for the terminal voltage and furthermore based on a correction term which depends on one or more operating parameters of the DC/AC inverter (202), and
- determining a state value (99) of the battery (91-96, 201) based on the corrected value of the terminal voltage,
**characterized in that** the processor is furthermore set up for executing the following steps:
- obtaining a measured value for a switching voltage and/or a switching frequency of one or more switching elements of the DC/AC inverter (202),
wherein the one or more operating parameters of the DC/AC inverter (202) include the switching voltage and/or the switching frequency.

9. Device according to Claim 8, wherein the processor is furthermore set up for executing the method according to one of Claims 1 to 7.

## Revendications

1. Procédé, lequel comprend les étapes suivantes :
- obtenir une valeur de mesure d'une tension aux bornes d'une batterie (91-96, 201) qui est couplée à une charge (69, 203) par le biais d'un convertisseur CC/CA (202),
- déterminer une valeur corrigée de la tension aux bornes sur la base de la valeur de mesure de la tension aux bornes et en outre sur la base d'un terme de correction qui dépend d'un ou plusieurs paramètres de fonctionnement du convertisseur CC/CA (202), et
- déterminer une valeur d'état (99) de la batterie (91-96, 201) sur la base de la valeur corrigée de la tension aux bornes,
**caractérisé en ce que** le procédé comprend en outre les étapes suivantes :
- obtenir une valeur de mesure d'une tension de commutation et/ou d'une fréquence de commutation à partir d'un ou plusieurs éléments de commutation du convertisseur CC/CA (202),
les un ou plusieurs paramètres de fonctionnement du convertisseur CC/CA (202) incluant la tension de commutation et/ou la fréquence de commutation.

2. Procédé selon la revendication 1, le procédé comprenant en outre l'étape suivante :
- obtenir une valeur de mesure d'un flux de courant dans le convertisseur CC/CA (202), les un ou plusieurs paramètres de fonctionnement du convertisseur CC/CA (202) incluant le flux de courant dans le convertisseur CC/CA (202).

3. Procédé selon la revendication 2,
le flux de courant comprenant au moins un flux de courant en mode commun et/ou un flux de courant en mode différentiel.

4. Procédé selon l'une des revendications précédentes, le procédé comprenant en outre l'étape suivante :
- déterminer le terme de correction par consultation d'une table de consultation sur la base des un ou plusieurs paramètres de fonctionnement du convertisseur CC/CA (202).

5. Procédé selon l'une des revendications précédentes, le procédé comprenant en outre l'étape suivante :
- paramétrer un circuit équivalent de la batterie (91-96, 201), qui est basé sur l'impédance (400), sur la base de la valeur corrigée de la tension aux bornes.

6. Procédé selon l'une des revendications précédentes,
la valeur de mesure de la tension aux bornes décrivant une tension en circuit ouvert de la batterie (91-96, 201).

7. Procédé selon l'une des revendications précédentes, le procédé comprenant en outre l'étape suivante :
- recevoir des données d'état (210) qui indiquent les un ou plusieurs paramètres de fonctionnement du convertisseur CC/CA (202).

8. Dispositif (61, 81) comprenant un processeur qui est conçu pour réaliser les étapes suivantes :
- obtenir une valeur de mesure d'une tension aux bornes d'une batterie (91-96, 201) qui est couplée à une charge (69, 203) par le biais d'un convertisseur CC/CA (202),
- déterminer une valeur corrigée de la tension aux bornes sur la base de la valeur de mesure de la tension aux bornes et en outre sur la base d'un terme de correction qui dépend d'un ou plusieurs paramètres de fonctionnement du convertisseur CC/CA (202), et
- déterminer une valeur d'état (99) de la batterie (91-96, 201) sur la base de la valeur corrigée de la tension aux bornes,
**caractérisé en ce que** le processeur est en outre conçu pour réaliser l'étape suivante :
- obtenir une valeur de mesure d'une tension de commutation et/ou d'une fréquence de commutation à partir d'un ou plusieurs éléments de commutation du convertisseur CC/CA (202),
les un ou plusieurs paramètres de fonctionnement du convertisseur CC/CA (202) incluant la tension de commutation et/ou la fréquence de commutation.

9. Dispositif selon la revendication 8, le processeur étant en outre conçu pour mettre en œuvre le procédé selon l'une des revendications 1 à 7.
